# EUROPEAN PATENT APPLICATION

(11) **EP 2 518 723 A1**
(43) Date of publication of application: **31.10.2012**
(21) Application number: 09852526.4
(22) Date of filing: 21.12.2009
(51) Int. Cl.: G10L 21/02, H03G 5/16

(54) **VOICE CONTROL DEVICE AND VOICE CONTROL METHOD**

(71) Applicant: Fujitsu Limited, Kawasaki-shi, Kanagawa 211-8588 (JP)
(72) Inventor: TOGAWA, Taro, Kawasaki-shi Kanagawa 211-8588 (JP); OTANI, Takeshi, Kawasaki-shi Kanagawa 211-8588 (JP); SUZUKI, Masanao, Kawasaki-shi Kanagawa 211-8588 (JP); OTA, Yasuji, Kawasaki-shi Kanagawa 211-8588 (JP)
(74) Representative: HOFFMANN EITLE
(86) International application number: PCT/JP2009/071253
(87) International publication number: WO 2011/077509

(57) **Abstract**

There is used a voice control unit controlling and outputting a first voice signal, the voice control unit including an analysis unit configured to analyze a voice characteristic of an inputted second voice signal; and a control unit configured to control an amplification of a spectrum of the first voice signal based on the analyzed voice characteristic.

## Description

### TECHNICAL FIELD

The embodiments discussed herein are related to a voice control device for controlling a voice signal, and more specifically, to a voice control method.

### BACKGROUND ART

There is a voice enhancing technique of changing voice characteristics of a received voice to thereby facilitate hearing of the received voice. An example system is configured such that ages of patients are acquired from a patient information database which is previously registered and the amplification amount of received voice is changed depending on the age to facilitate hearing of the received voice.

An example interphone makes it possible to facilitate hearing of the received voice when a user switches frequency characteristics of the received voice. Further, auditory properties may differ depending on differences of age or sexuality.

### [Patent Document]

[Patent Document 1] Japanese Laid-open Patent Publication No. 2007-318577
[Patent Document 2] Japanese Laid-open Patent Publication No. 11-261709

### [Non Patent Document]

[Non Patent Document 1] Yamamoto, Taijirou, Building environment for aged person, pages 72-73, SHOKOKUSHA Publishing Co., Ltd, January 10, 1994

### SUMMARY

According to the above, it is necessary to register age information to the database and register user identification information to an enhancing device. In order to realize effects to many users, a great amount of data capacity is necessary and great time and effort are necessary. Further, since a prior registration is necessary, some users may not enjoy the effects. Further, since a change of the user identification information is not considered for each of the enhancing devices, if a user is changed the changed user may not enjoy the effects.

Further, according to the above, it is necessary to manually switch a frequency characteristic. Therefore, it is not possible to effect a user who is not familiar with a switching operation.

The purpose of the present invention is to analyze the sending signal from the user and to make a user hear an output voice easier.

A disclosed voice control unit controlling and outputting a first voice signal includes an analysis unit configured to analyze a voice characteristic of an inputted second voice signal; and a control unit configured to control an amplification of a spectrum of the first voice signal based on the analyzed voice characteristic.

A disclosed voice control method of controlling and outputting a first voice signal includes analyzing a voice characteristic of an inputted second voice signal; and controlling an amplification of a spectrum of the first voice signal based on the analyzed voice characteristic.

### Effect of the invention

The disclosed voice control device analyzes a sending signal from a user and controls the voice output by the user based on the analyzed result so as to be hear easier.

### BRIEF DESCRIPTION OF DRAWINGS

FIG. 1 illustrates differences of auditory property depending on sexuality;
FIG. 2 is an exemplary block chart of a voice control device 10 of a first embodiment;
FIG. 3 is an exemplary block chart of a voice control device 20 of a second embodiment;
FIG. 4 illustrates differences of power gradients in a high frequency depending on sexuality;
FIG. 5 illustrates exemplary amplification information of the second embodiment;
FIG. 6 is a flowchart for illustrating a voice control process of the second embodiment;
FIG. 7 is a block chart illustrating an exemplary functional structure of a voice control device 30 of a third embodiment;
FIG. 8 illustrates differences of formant frequencies depending on sexuality;
FIG. 9 illustrates exemplary amplification information of the third embodiment;
FIG. 10 is a flowchart of an exemplary voice control process of the third embodiment;
FIG. 11 is an exemplary functional structure of a voice control device 40 of a fourth embodiment;
FIG. 12 illustrates exemplary amplification information of the fourth embodiment;
FIG. 13 is a flowchart of an exemplary voice control process of the fourth embodiment; and
FIG. 14 illustrates an exemplary portable phone of a fifth embodiment.

### EXPLANATION OF REFERENCE SYMBOLS

10, 20, 30, 40: voice control device;
101, 201, 301: feature analyzation unit;
103, 205, 305: control unit;
203: gradient calculating unit;
207, 307, 403: determining unit;
209, 309, 405: judging unit;
211: amplification unit;
213, 311, 407: amplification information;
303: formant calculating unit; and
401: noise detecting unit.

### BEST MODE FOR CARRYING OUT THE INVENTION

The embodiments are described below with reference to figures.

### First Embodiment

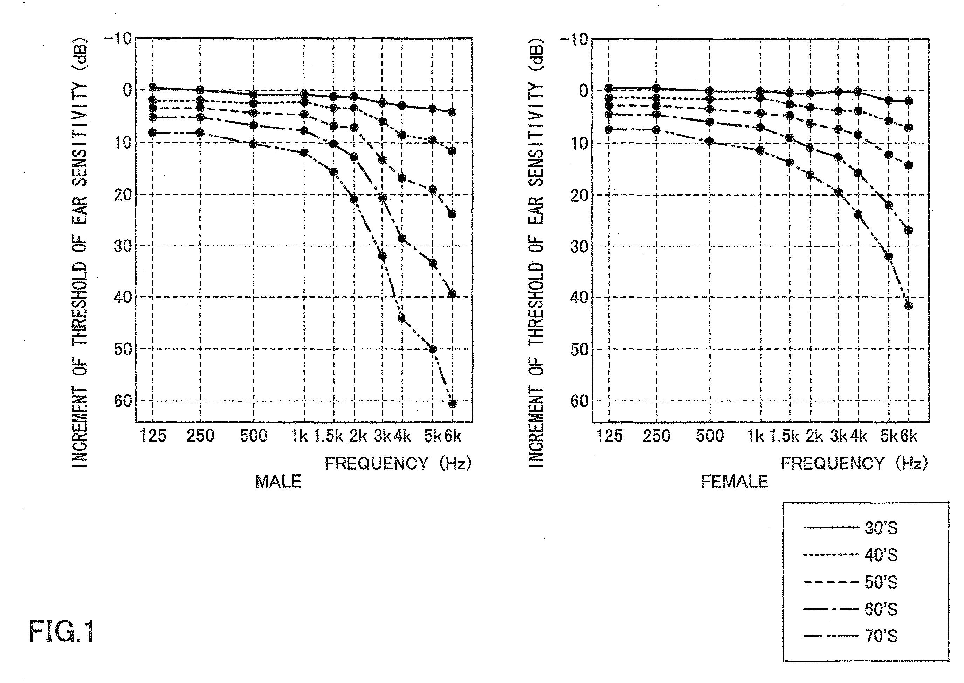

Differences of auditory properties depending on age and sexuality are described in Non Patent Document 1. FIG. 1 illustrates differences of the auditory property depending on the age and sexuality in comparison with 20's (Non Patent Document 1). Referring to FIG. 1, males become harder to hear a voice than females do. Specifically, as the frequency becomes higher, the differences depending on the sexuality become greater.

Described next is the voice control device for controlling to change a voice signal (hereinafter, referred to as a sending signal) spoken by a user to an output sound easily heard using differences of auditory properties depending on the sexuality as illustrated in FIG. 1.

### <Functional structure>

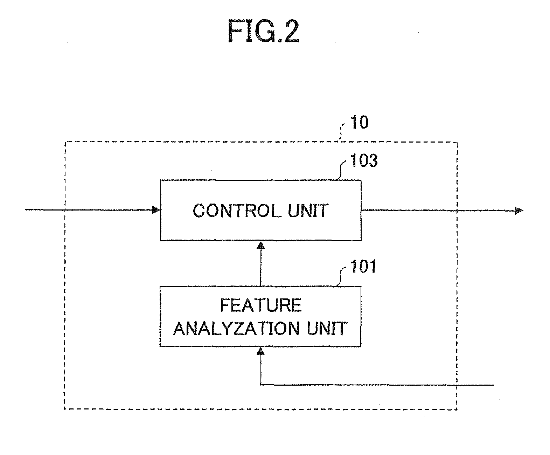

FIG. 2 is an exemplary block chart of a voice control device 10 of a first embodiment. The voice enhancing (control) device 10 includes a feature analyzation unit 101 and a control unit 103. The voice control device 10 analyzes a second voice signal (e.g., a sending signal) input in the voice control device 10, and amplifies a first voice signal (e.g., a receiving signal) which is output from the voice control device 10 based on the analyzed voice characteristic.

The feature analyzation unit 101 illustrated in FIG. 2 calculates a voice feature quantity of a sending signal from the user. The voice feature quantity is, for example, a gradient of a spectrum in a predetermined band, a formant frequency, or the like. The feature analyzation unit 101 outputs the calculated voice feature quantity to the control unit 103.

The control unit 103 amplifies the spectrum of the voice signal output from the voice control device 10 based on the obtained voice feature quantity. When the spectrum of the voice signal is amplified, an amplification band and an amplification amount which are respectively associated with values of voice feature quantity are stored in a memory, and the control unit 103 determines the amplification band and the amplification amount associated with the voice feature quantity with reference to the memory.

Next, the control unit 103 amplifies the input spectrum (a receiving signal) to be the spectrum of the determined amplification band by the determined amplification amount.

With this, the output received voice may be controlled based on the voice characteristics of the voice spoken by the user to thereby enable being easily heard depending on the voice characteristic of the user.

### Second Embodiment

Next, the voice control device 20 of the second embodiment is described. Referring to the second embodiment, the feature analyzation unit 201 calculates the gradient of the power spectrum. Within the second embodiment, the amplification band and the amplification amount are determined based on the gradient of the power spectrum, and the spectrum of the output voice signal is amplified.

### <Functional structure>

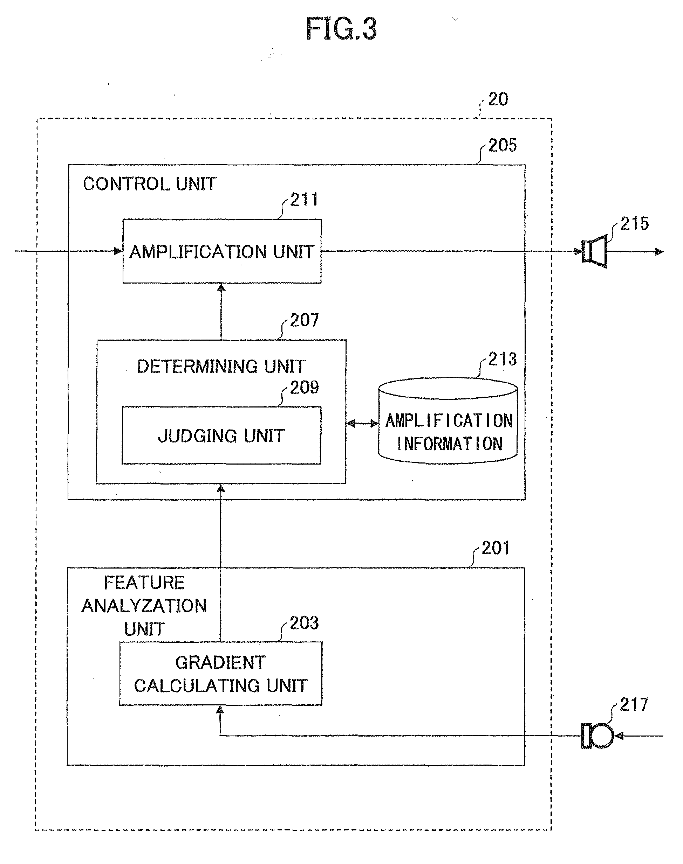

FIG. 3 is an exemplary block chart of the voice control device 20 of the second embodiment. As illustrated in FIG. 3, the voice control device 20 includes a feature analyzation unit 201 and a control unit 205. The feature analyzation unit 201 includes a gradient calculating unit 203. The control unit 205 includes a determining unit 207, an amplification unit 211, and an amplification information 213.

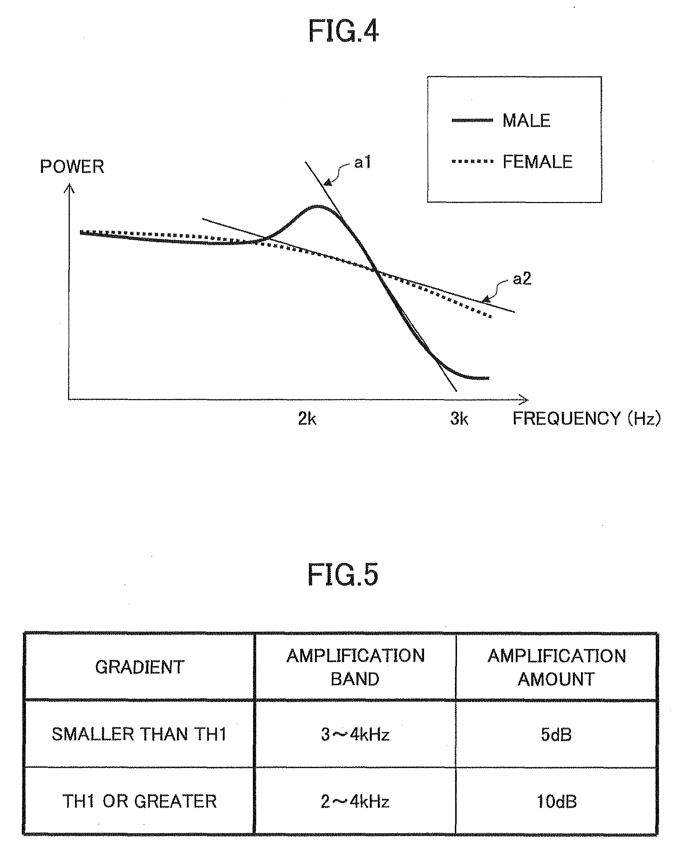

The gradient calculating unit 203 obtains a sending signal from the microphone 217 by the user, and transforms it into the spectrums for each frame. Next, the gradient calculating unit 203 calculates a power gradient in a high frequency of the power spectrum (hereinafter, simply referred to as "power"). Referring to FIG. 4, differences of males and females appear in the power gradients in the high frequency.

FIG. 4 illustrates differences of the power gradients in the high frequency depending on sexuality. Experimental conditions of FIG. 4 are as follows.
- Conversations of seven males and seven females seven (conversations recorded in a commercially available database (DB)) undergo spectrum transformation and the average of the spectrum is obtained.
- 160 samples are obtained per one frame (8 kHz sampling).
- The power gradients in the high frequency are obtained for each of the frames (the average powers of 2250 to 2750 and the average powers of 2750 to 3250 are obtained).
- The average values of the power gradients in the high frequency for 2 seconds are obtained.

The experimental result is simplified and illustrated by the waveform of FIG. 4. Referring to FIG. 4, the absolute value of the gradient a1 of males is higher than the absolute value of the gradient a2 of females. Within the second embodiment, the sexuality of males or females is determined using the difference of the gradients. Hereinafter, the gradient means the absolute value of the gradient.

Referring back to FIG. 3, the gradient calculating unit 203 outputs the power gradient calculated as illustrated in FIG. 4 to the determining unit 207. The conditions of calculating the power gradient are not limited to those illustrated in FIG. 4 as long as a difference between males and females can be observed.

The gradient calculating unit 203 may calculate the gradient at every obtention of the sending signal or at every predetermined time period. If the gradient is calculated at every predetermined time period, an operation in calculating the gradient can become easy. After the gradient calculating unit 203 calculates the gradient, the calculated gradient may be output to the determining unit 207 only when the gradient changes beyond a predetermined threshold value (a threshold TH1 described below). Thus the determining unit 207 can determine the amplification band and the amplification amount only when it is necessary.

The determining unit 207 determines the amplification band and the amplification amount based on the power gradient obtained from the feature analyzation unit 201. Specifically, the determining unit 207 refers to the amplification information 213 as illustrated in FIG. 5 to thereby determine the amplification band and the amplification amount.

FIG. 5 illustrates an exemplary amplification information of the second embodiment. Referring to FIG. 5, the amplification information associates the amplification band with the amplification amount in response to the gradient value. For example, if the gradient value is smaller than the threshold value TH1, the amplification band is 3 to 4 kHz and the amplification amount is 5 dB. Although the amplification band and the amplification amount are determined based on the data illustrated in FIG. 1, the embodiments are not limited thereto. The amplification band and the amplification amount may be appropriately determined by an experiment. The amplification information 213 may be stored in a memory outside the determining unit 207 and retained inside the determining unit 207.

Referring back to FIG. 3, the determining unit 207 includes the judging unit 209. The judging unit 209 determines whether the power gradient is the threshold value TH1 or greater. Here, the threshold value TH1 is, for example, 4 dB/kHz. The judging unit 207 may determine that a gradient of TH1 or greater corresponds to male and a gradient smaller than TH1 corresponds to female.

The determining unit 207 refers to the amplification information 213 depending on the judgment result by the judging unit 209 thereby determining the amplification band and the amplification amount. For example, if the gradient is TH1 or greater, the amplification band is 2 to 4 kHz and the amplification amount is 10 dB. The determining unit 207 outputs the determined amplification band and the determined amplification amount to the amplification unit 211.

The amplification unit 211 acquires the amplification band and the amplification amount from the determining unit 211 and generates the spectrum by performing time-frequency conversion for the acquired voice signal. Next, the amplification unit 211 amplifies the generated spectrum by an amplification amount in the amplification band and performs the frequency-time conversion for the amplified spectrum. Next, the amplification unit 211 outputs the amplified voice signal to the speaker 215. The amplification unit 211 performs the time-frequency conversion and the frequency-time conversion. However, these processes may be performed outside the amplification unit 211.

The speaker outputs an enhanced voice.

### (Operations)

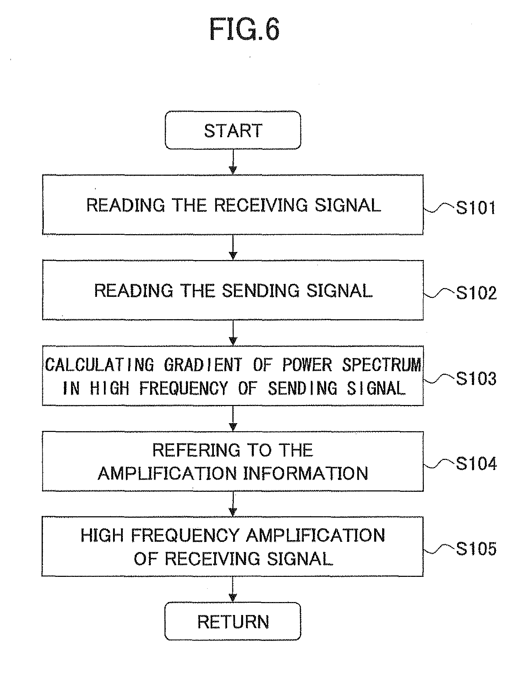

Next, the voice control device 20 of the second embodiment is described. FIG. 6 is a flowchart for illustrating a voice control process of the second embodiment. In step S101 illustrated in FIG. 6, the amplification unit 211 reads a receiving signal.

In step S102, the gradient calculating unit 203 reads a sending signal. The order of steps S101 and S102 can be reversed. In step S103, the gradient calculating unit 203 calculates the gradient of the power spectrum in the high frequency of the sending signal. The high frequency corresponds to the spectrum of 2250 kHz or greater. The characteristic of males appears at around the spectrum of 2250 kHz (see FIG. 4).

In step S104, the determining unit 207 refers to the amplification information based on the gradient of the power spectrum to thereby determine the amplification band and the amplification amount.

In step S105, the amplification unit 211 amplifies the spectrum of the receiving signal at the high frequency. Specifically, the amplification unit 211 amplifies the spectrum in the determined amplification band by the determined amplification amount. The amplified spectrum undergoes the frequency-time conversion and then is output.

The process of calculating the gradient in step S103 and the process of determining the amplification band and the amplification amount may be processed only when it is necessary. The receiving signal contains the voice signal previously stored in a memory and a voice signal received via a network.

As described, within the second embodiment, the power gradient of the spectrum power at the high frequency is calculated from the sending signal from the user and the receiving signal is amplified in conformity with the gradient thereby outputting the emphasized voice.

### Third Embodiment

Next, the voice control device 30 of the third embodiment is described. Within the third embodiment, a formant frequency is calculated by a feature analyzation unit 301. Within the third embodiment, the amplification band and the amplification amount are determined based on the formant frequency, and the spectrum of the output voice signal is amplified.

### <Functional structure>

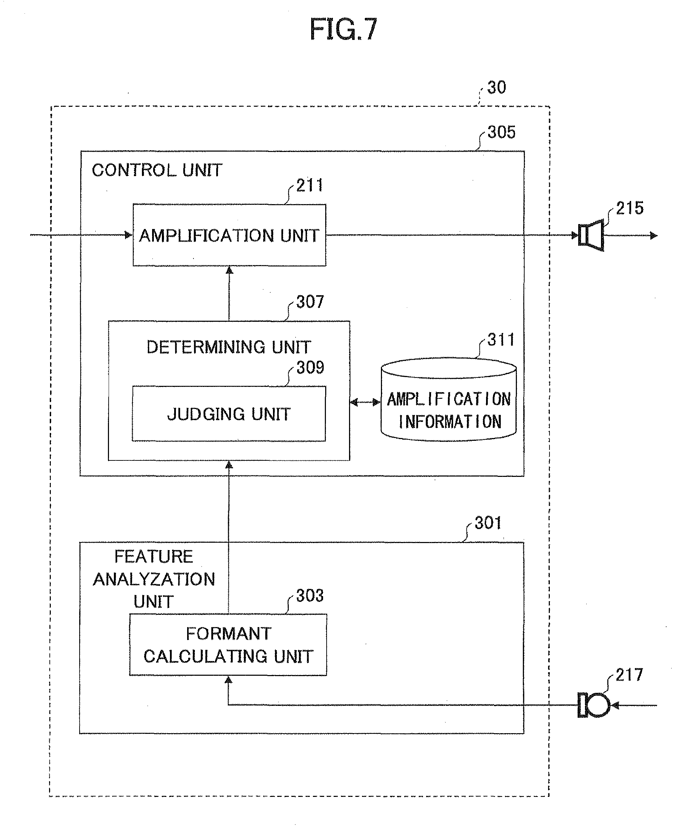

FIG. 7 is an exemplary block chart of a voice control device 30 of the third embodiment. Referring to FIG. 7, the identical numerical references are used for functions similar to those in FIG. 3, and description of these functions is omitted.

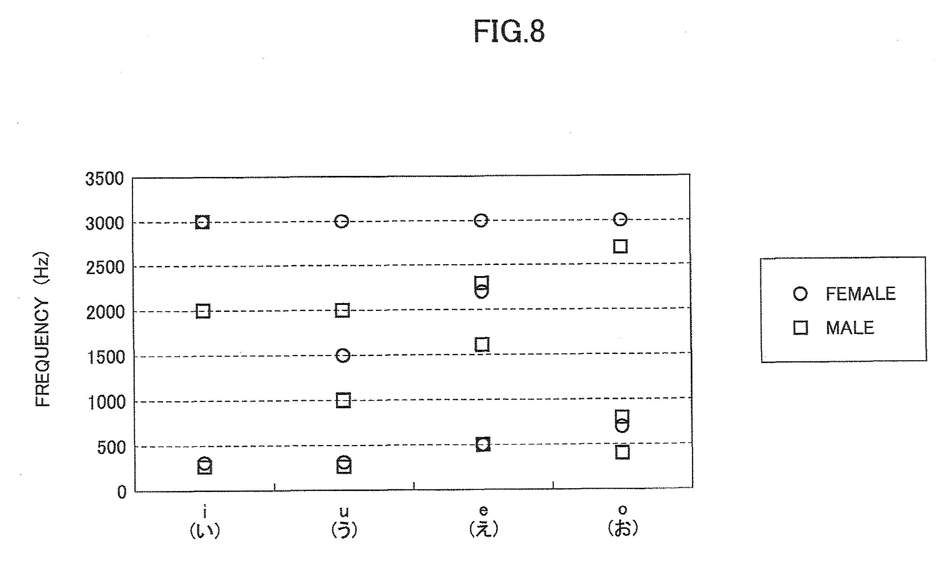

The feature analyzation unit 301 includes a formant calculating unit 303. The formant calculating unit 303 analyzes the sending signal by performing, for example, a linear predictive coding (LPC) for the sending signal to extract the peak and to thereby extract the formant frequency. The formant calculating unit 303 may extract the formant frequency by performing, for example, a line spectrum pair (LSP) thereby extracting the formant frequency. The formant calculating unit 303 may calculate the formant frequency using any one of known techniques. At the formant frequency, differences between males and females appear as illustrated in FIG. 8.

FIG. 8 illustrates differences of formant frequencies depending on sexuality. Experimental conditions of FIG. 8 are as follows.
- One male and one female
- Measure frequencies (formant frequencies) dominant in their power spectrums respectively for vowels

FIG. 8 illustrates an exemplary experimental result. Please also refer to URL (http://www.mars.dti.ne.jp/-stamio/sound.htm) to understand this experiment. Referring to FIG. 8, a first formant, a second formant, and a third formant for the male and the female are sequentially listed from a lower frequency to a higher. Referring to FIG. 8, the formant frequencies for the female are smaller than the formant frequencies for the male. Within the third embodiment, the sexuality of males or females is determined using the difference of the formant frequencies.

Referring back to FIG. 7, the formant calculating unit 303 outputs formant frequencies extracted from frames of voice data having a length of about 2 seconds to the determining unit 307.

The formant calculating unit 303 may calculate the formant frequencies for each predetermined time period. If the formant frequency is calculated for each predetermined time, it is possible to reduce an operation in calculating the formant frequency. After the formant calculating unit 303 calculates the formant frequencies, only when the following condition is satisfied, the formant frequencies may be output to the determining unit 307. The condition to be satisfied is an inversion of the total number of the formant frequencies in the first formant frequency and the total number of the formant frequencies in the second formant frequency. Thus, the determining unit 307 can determine the amplification band and the amplification amount only when it is necessary.

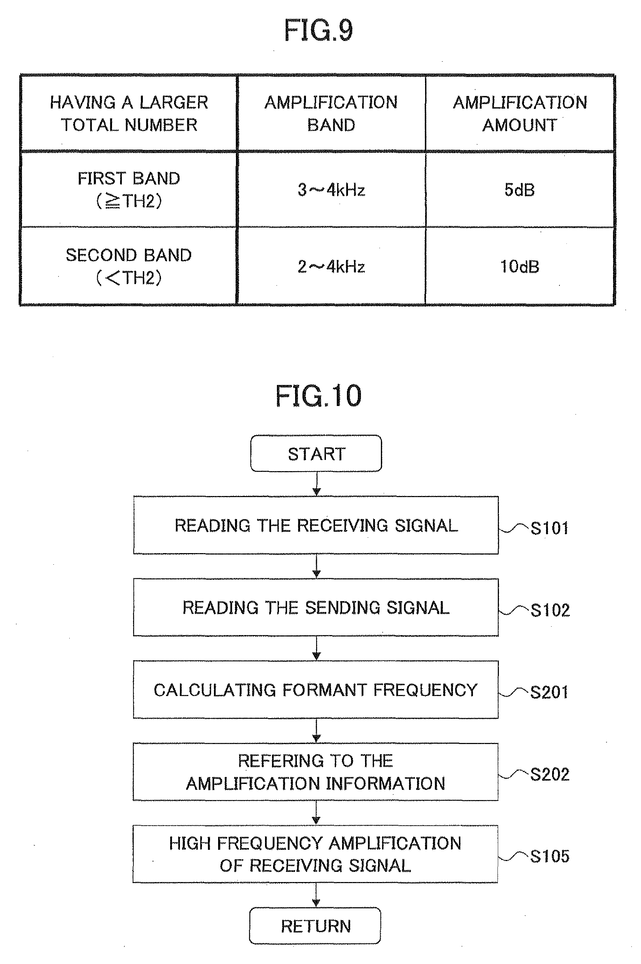

The determining unit 307 determines the amplification band and the amplification amount based on the formant frequencies obtained from the feature analyzation unit 301. Specifically, the determining unit 307 refers to the amplification information 311 as illustrated in FIG. 9 to thereby determine the amplification band and the amplification amount.

FIG. 9 illustrates exemplary amplification information of the third embodiment. Referring to the amplification information illustrated in FIG. 9, the amplification band and the amplification amount are associated with the total numbers of the formant frequencies in the two predetermined bands, which are divided at a border of TH2. For example, when the total number of the formant frequencies in a predetermined band (the first band) of TH2 or greater is greater than the total number of the formant frequencies in a predetermined band (the second band) of smaller than TH2, the amplification band is 3 to 4 kHz and the amplification amount is 5 dB. The amplification information 311 may be stored in a memory outside the determining unit 307 and retained inside the determining unit 307.

TH2 is, for example, 2750 Hz. If TH2 is 2750 Hz, the second band is 2250 to 2750 Hz and the first band is 2750 to 3250 Hz. However, the above frequencies are only examples.

Referring to FIG. 7, the determining unit 307 includes a judging unit 309. The judging unit 309 judges whether the total number of the formant frequencies in the first band is greater than, equal to, or smaller than the total number of the formant frequencies in the second band is great. The judging unit 307 may judge a voice is from a female if the number of the formant frequencies in the first band is greater than the number of the formant frequencies in the second band, or a voice is from a male if the number of the formant frequencies in the second band is greater than the number of the formant frequencies in the first band. As illustrated in FIG. 8, the formant frequencies of vowels by the females exist at 3000 Hz, and the formant frequencies of vowels by the males scarcely exist at 3 000 Hz. Therefore, this difference is used in the determination.

The determining unit 307 refers to the amplification information 311 depending on the judgment result by the judging unit 309 thereby determining the amplification band and the amplification amount. For example, if the total number of the second band is greater the amplification band is 2 to 4 kHz and the amplification amount is 10 dB. The determining unit 307 outputs the determined amplification band and the determined amplification amount to the amplification unit 211. The amplification unit 211 is as described above.

### (Operations)

Next, the voice control device of the third embodiment is described. FIG. 10 is a flowchart for illustrating a voice control process of the third embodiment. Referring to FIG. 10, the identical numerical references are used for processes similar to those in FIG. 6, and description of these processes is omitted.

In step S201, the formant calculating unit 303 calculates formant frequencies of the sending signal.

In step S202, the determining unit 307 refers to the amplification information based on the formant frequencies to thereby determine the amplification band and the amplification amount. The process of specifically determining the amplification band and the amplification amount is as described above.

In step S105, in a manner similar to the second embodiment, the amplification unit 211 amplifies the spectrum of the receiving signal at the high frequency. Specifically, the amplification unit 211 amplifies the spectrum in the determined amplification band by the determined amplification amount.

Within the third embodiment described above, the formant frequency is calculated from the sending signal from the user and amplifies the receiving signal in response to the formant frequency to thereby output an emphasized voice.

### Fourth Embodiment

Next, a voice control device 40 of the fourth embodiment is described. Within the fourth embodiment, in addition to the structure of the first embodiment, a noise detecting unit 401 is newly added. Within the fourth embodiment, the amplification band and the amplification amount are determined in consideration if a noise level detected by the noise detecting unit 401, and the spectrum of the output voice signal is amplified.

### <Functional structure>

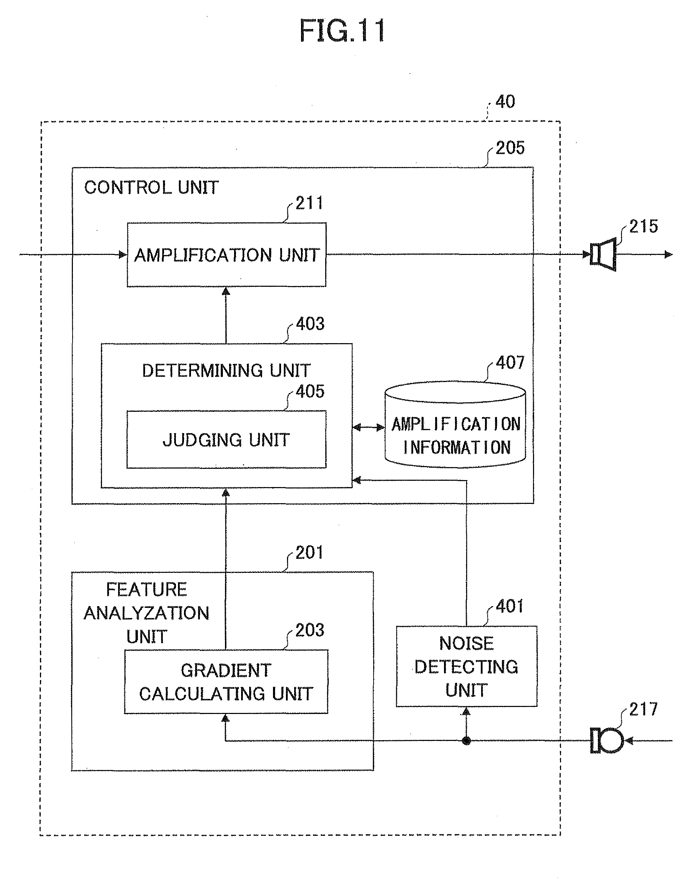

FIG. 11 is an exemplary block chart of the voice control device 40 of the fourth embodiment. Referring to FIG. 11, the identical numerical references are used for functions similar to those in FIG. 3, and description of these functions is omitted.

The noise detecting unit 401 uses a known noise detecting technology and detects an environmental noise level from the sending signal. The exemplary noise detecting technology is to calculate a long term average level and separate voice from noise in response to a result of comparing the long term average level with subject sound. The noise detecting unit 401 outputs the detected noise level to the determining unit 403.

The determining unit 403 determines the amplification band and the amplification amount based on the gradient acquired from the gradient calculating unit 203 and the noise level acquired from the noise detecting unit 401. The determining unit 403 includes a judging unit 405 for judging whether the noise level is a threshold value of 3 or greater in addition to the function of the second embodiment. The threshold TH3 may be appropriately set by reflecting the results of experiments.

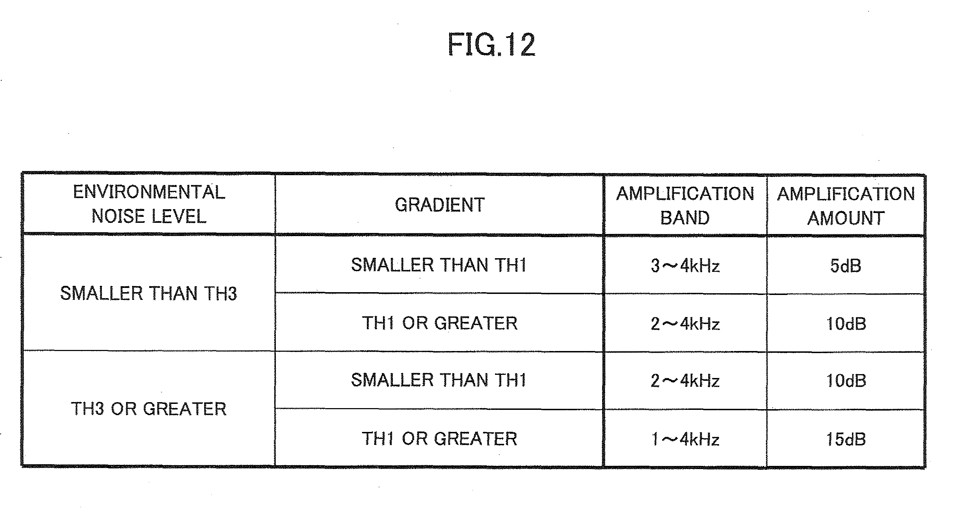

The determining unit 403 refers to amplification information 407 depending on the judgment result by the judging unit 405 thereby determining the amplification band and the amplification amount. FIG. 12 illustrates exemplary amplification information of the fourth embodiment. Referring to FIG. 12, the amplification band and the amplification amount are changed based on whether a noise level is TH3 or greater and whether a gradient is TH1 or greater For example, if the noise level is TH3 or greater and the gradient is TH1 or greater the amplification band becomes 1 to 4 kHz and the amplification amount becomes 15 dB.

If the amplification band and the amplification amount are determined by the determining unit 403, the amplification unit 211 amplifies the receiving signal based on the determined amplification band and the determined amplification amount.

TH3 may be set to be great enough to avoid the judgment using the gradient. If the noise level is TH3 or greater a predetermined band is set to be an amplification band and a predetermined amount is set to be an amplification amount irrespective of the gradient. This is because the judgment using the gradient becomes impossible if the noise level becomes a predetermined value or greater The predetermined band is an average band in a case where the noise level is smaller than TH3, and the predetermined amplification amount is an average amplification amount in a case where the noise level is smaller than TH3.

Thus, when the sexuality is not judged by the gradient, an average of receiving signals from a male and a female is amplified to judge whether the receiving signal is from a male or a female.

### (Operations)

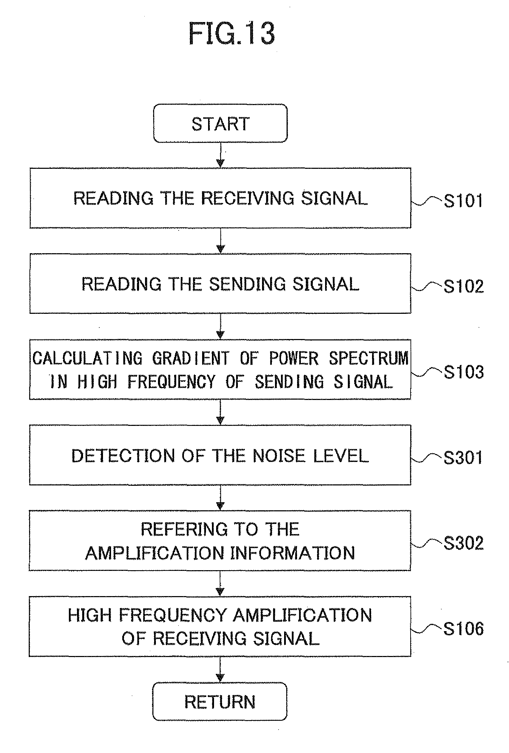

Next, the voice control device 40 of the fourth embodiment is described. FIG. 13 is a flowchart for illustrating a voice control process of the fourth embodiment. Referring to FIG. 13, the identical numerical references are used for processes similar to those in FIG. 6, and description of these processes is omitted.

In step S301, the noise detecting unit 401 detects the noise level of the sending signal.

In step S302, the determining unit 403 refers to the amplification information based on the gradient and the noise level to thereby determine the amplification band and the amplification amount. The process of specifically determining the amplification band and the amplification amount is as described above.

In step S106, in a manner similar to the second embodiment, the amplification unit 211 amplifies the spectrum of the receiving signal at the high frequency. Specifically, the amplification unit 211 amplifies the spectrum in the determined amplification band by the determined amplification amount.

As described, within the fourth embodiment, the noise level is detected and the power gradient of the spectrum power at the high frequency is calculated from the sending signal from the user and the receiving signal is amplified in conformity with the noise level and the gradient thereby outputting the emphasized voice.

Within the fourth embodiment, the noise detecting unit 401 is added to the structure of the voice control device 20 of the second embodiment. However, the noise detecting unit 401 may be added to the structures of the voice control devices 10 and 30 of the first and third embodiments.

Further, the embodiments are provided to amplify the receiving signal in the amplification band by the amplification amount. However, the amplification amount may be increased more as the frequency becomes higher than the amplification band. The amplification band and the amplification amount may be appropriately set based in the data illustrated in FIG. 1 and the other experimental results. The threshold value of the amplification information 407 may be 2 or greater The amplification unit may not always amplify only the high frequency. It is possible to amplify the receiving signal at a low range by a necessary amount.

### Fifth Embodiment

Next, a portable phone of the fifth embodiment is described. Within the fifth embodiment, an example that the voice control device 10 is installed in a portable phone as a voice control unit as hardware is described. It is not limited only to the voice control unit 10 of the first embodiment, any one of the voice control devices 20, 30 and 40 of the second to fourth embodiments may be installed in the portable phone. Within the fifth embodiment, the voice control devices of the first to fourth embodiments are not installed as the voice control unit of the hardware in the portable phone, and can be installed as the above-described voice control process of software in the portable phone.

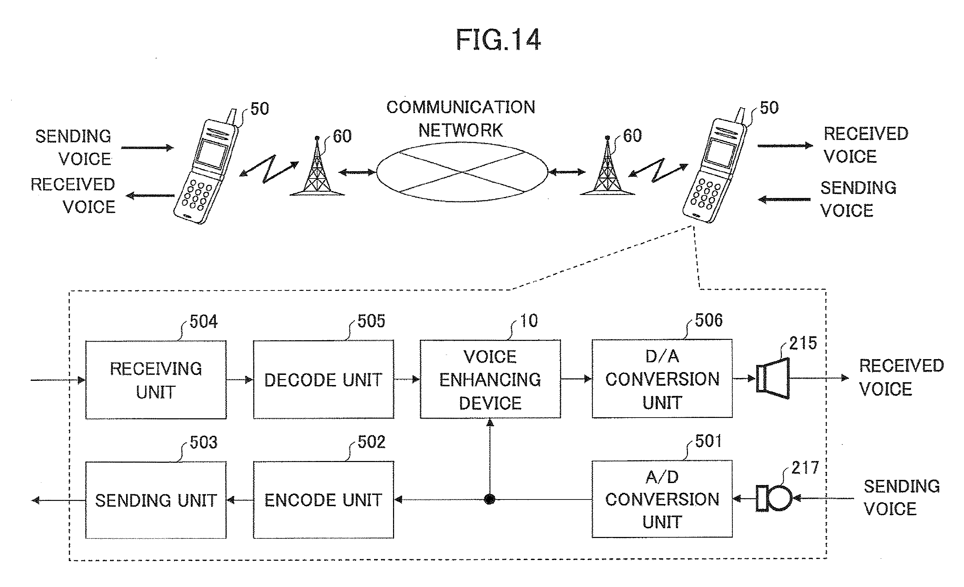

FIG. 14 illustrates an exemplary portable phone of the fifth embodiment. The portable phone 50 illustrated in FIG. 5 sends and receives the coded sending signal to and from the base station 60.

The portable phone 50 illustrated in FIG. 14 includes an A/D conversion unit 501, an encode unit 502, a sending unit 503, a receiving unit 504, a decode unit 505, a voice control device 10, and a D/A conversion unit 506.

The A/D conversion unit 501 converts a sending voice output from a microphone 217 from an analog signal to a digital signal. The converted signal (the sending signal) is output to the voice control device 10 and the encode unit 502.

The encode unit 502 generates an encoded signal with an ordinary voice encoding technique using the portable phone. The sending unit 503 sends the encoded signal obtained by the encode unit 502 to the base station 60.

The receiving unit 504 receives the coded signal from the base station 60. The decode unit 505 decodes the coded signal and converts the coded signal to a voice signal (a receiving signal).

The voice control device 10 acquires voice characteristics from the sending signal and amplifies the receiving signal based on the acquired voice characteristics. The voice control device 10 outputs the amplified voice signal to the D/A conversion unit 506.

The D/A conversion unit 506 converts the amplified voice signal from a digital signal to an analog signal. The voice signal converted to the analog signal is output as a received voice emphasized by the speaker 215.

Within the fifth embodiment, the voice control device 10 is installed in the portable phone. However, an apparatus to which the voice control device 10 is installed is not limited to the portable phone. For example, the above-described voice control devices and the above-described voice control processes are applicable to information processing apparatuses such as a video teleconference device, an automatic answering equipment (AAE) using speech of a user. Functions of the portable phone, the video teleconference and the automatic answering equipment (AAE) may be realized by the voice control device.

Within the fifth embodiment, if the decode unit 505 and the voice control device 10 are integrated into one unit, the time-frequency conversion performed inside the voice control device 10 can be omitted. Further, within the above embodiments, the voice is stressed. However, there may be a case where the gain of the spectrum is reduced instead of amplifying the spectrum. Within the embodiments, it is possible to control spectrum elements of music or the like in addition to the voice in order to acquire an output sound easily heard by a user.

The sound control process described in the above-embodiment may be realized as a program to be performed by the computer. By installing the program from a server or the like and causing the computer to carry out, the above-described sound control process is realized.

Furthermore, the program may be recorded onto a recording medium (a CD-ROM, an SD card and so on) to enable a computer or a portable terminal reading out the program from the recording medium to thereby realize the above-described voice control process. The recording medium may be a recording medium optically, electrically or magnetically recording information such as a CD-ROM, a flexible disc and a magnet-optical disc, a semiconductor memory for electrically recording information such as a ROM and a flash memory, or various types of recording mediums. The voice control process described in the above-described embodiment may be installed in one or plural integrated circuits.

Although the embodiments of the present invention have been described in detail, it should be understood that the various changes, substitutions, and alterations could be made hereto without departing from the spirit and scope of the invention.

## Claims

1. A voice control unit controlling and outputting a first voice signal, the voice control unit comprising:
an analysis unit configured to analyze a voice characteristic of an inputted second voice signal; and
a control unit configured to control an amplification of a spectrum of the first voice signal based on the analyzed voice characteristic.

2. The voice control device according to claim 1,
wherein the analysis unit includes a calculation unit for calculating a gradient of the spectrum at a high frequency of the second voice signal as the voice characteristic, and
the control unit includes
a determination unit for determining the amplification band and the amplification amount based on the gradient, and
an amplification unit for amplifying the spectrum of the second voice signal to realize the determined amplification band and the determined amplification amount.

3. The voice control device according to claim 1,
wherein the analysis unit includes a calculation unit for calculating a formant frequency of the second voice signal as the voice characteristic, and
the control unit includes
a determination unit for determining an amplification band and an amplification amount respectively of the spectrum of the first voice signal based on the formant frequency, and
an amplification unit for amplifying the spectrum of the first voice signal to realize the determined amplification band and the determined amplification amount.

4. The voice control device according to any one of claims 1 to 3,
wherein the second voice signal is a sending signal input in the voice control device, and
the first voice signal is a receiving signal output from the voice control device.

5. The voice control device according to any one of claims 2 to 4,
wherein the determination unit determines the amplification band and the amplification amount respectively of the spectrum of the first voice signal based on amplification information by which the voice characteristic is associated with the amplification band and the amplification amount.

6. The voice control device according to any one of claims 2 to 5,
wherein the determination unit determines sexuality based on the voice characteristic and determines the amplification band and the amplification amount based on a result of the determination of the sexuality.

7. The voice control device according to any one of claims 1 to 6, further comprising:
a noise detection unit for detecting noise contained in the second voice signal,
wherein the control unit controls the amplification of the spectrum of the first voice signal based on the detected noise and the analyzed voice characteristic.

8. A voice control method of controlling and outputting a first voice signal, the voice control method comprising:
analyzing a voice characteristic of an inputted second voice signal; and
controlling an amplification of a spectrum of the first voice signal based on the analyzed voice characteristic.
